(19) Europäisches Patentamt

European Patent Office

Office européen des brevets

(11) **EP 1 005 076 A1**

(12) **EUROPEAN PATENT APPLICATION**
published in accordance with Art. 158(3) EPC

(43) Date of publication:
**31.05.2000 Bulletin 2000/22**

(51) Int. Cl.⁷: **H01L 21/68**, B23Q 3/08

(21) Application number: **98907223.6**

(22) Date of filing: **13.03.1998**

(86) International application number:
**PCT/JP98/01070**

(87) International publication number:
**WO 98/42017 (24.09.1998 Gazette 1998/38)**

(84) Designated Contracting States:
**DE GB NL**

(30) Priority: **14.03.1997 JP 6158497**

(71) Applicants:
• **KABUSHIKI KAISHA WATANABE SHOKO**
 **Chuo-ku, Tokyo 103-0022 (JP)**
• **Toda, Masayuki**
 **Yonezawa-shi, Yamagata 992 (JP)**

(72) Inventors:
• **TODA, Masayuki**
 **Yonezawa-shi, Yamagata-ken 992-0026 (JP)**
• **UMEDA, Masaru,**
 **K. Kaisha Watanabe Shoko**
 **Chuo-ku, Tokyo 103-022 (JP)**
• **KANNO, Yoichi**
 **Sendai-shi, Miyagi-ken 980-0805 (JP)**
• **OHMI, Tadahiro**
 **Sendai-shi, Miyagi-ken 980-0813 (JP)**

(74) Representative:
**Dr. Weitzel & Partner**
**Friedenstrasse 10**
**89522 Heidenheim (DE)**

(54) **FLOATING APPARATUS OF SUBSTRATE**

(57) It is an object of the present invention to provide a substrate body floating apparatus which insures a stable floating state of a substrate body with less vibration of a rotation axis or a surface thereof and a heater and a film-forming apparatus capable of forming a homogeneous film without losing cleanliness of a surface of a substrate body and with small temperature gradation on a surface of a substrate body as well as small density gradation of a raw material used for forming a film on a substrate body in a wide area.

The substrate body floating apparatus according to the present invention has a floating unit for floating and rotating a disk-shaped substrate body by blowing an air flow to a rear surface of the substrate body, said floating unit comprising a group of fine pores for floating the substrate body, a group of fine pores for fixing the substrate body at a center of the apparatus, a group of fine pores for rotating the substrate body at a center of the apparatus, and a group of auxiliary fine pores for suppressing vibration of the substrate body when the substrate body is rotated at a high speed. Also the substrate body floating type of heater and film-forming apparatus have the floating unit described above respectively.

F i g . 1

Printed by Xerox (UK) Business Services
2.16.7 (HRS)/3.6

## Description

### FIELD OF THE INVENTION

The present invention relates to a substrate body floating apparatus, substrate body floating type of heater and a film-forming apparatus. More specifically the present invention relates to a substrate body floating apparatus capable of realizing a stable floating state with less vibration of a rotation axis and a surface of a substrate body as well as to a substrate body floating type of heater and a film-forming apparatus capable of heating a substrate body and film formation respectively without losing cleanliness of a surface of a substrate body.

### BACKGROUND TECHNOLOGY

In association with functional advance in the field of semiconductor devices, the tendency for more minute and more highly integrated devices is further promoted, and now there are strong demands for more advanced production technology in the field. Especially, a memory capacity of a ULSI, one of more advanced semiconductor devices formed by subjecting water for surface processing, is now expected to enter the stage of Giga bit in the beginning of the 21-st century. However, it will become more and more difficult to insure stable production and supply of DRAMs each with a memory capacity of several G-bit which must be produced in the near future only with extension of the current production technology. To continuously produce high quality devices with advanced functions such as a DRAM with several G-bit memory capacity under stable conditions, there is required a technology applicable in water surface processing in device production in which process parameters are completely controlled and does not allow existence of extremely fine foreign materials causing contamination of a wafer surface. In an apparatus based on the conventional technology, a wafer is placed on a susceptor in a contact state, and wafer surface processing is executed to a not-contacting surface thereof, but with this system, it is becoming harder to reduce contamination of a wafer surface. Further, in association with increase of a capacity of semiconductor devices to be produced, a diameter of a wafer as a substrate body to be used in the production becomes larger (a wafer with a diameter of 12 inches is required for production of 64M DRAM), so that, with the conventional type of wafer surface processing apparatus, it is becoming harder to provide controls so that temperature gradation on a surface of a substrate body or density gradation in a raw material to be used for forming a film on a substrate body will not be generated.

It is an object of the present invention to provide a substrate body floating apparatus capable of realizing a stable floating state with less vibration of a rotary shaft or a surface and a substrate body floating type of heater and a film-forming apparatus capable of forming a film without losing cleanliness of a surface of a substrate body and with small temperature gradation on a surface of a substrate body small density gradation in a raw material to be used for forming a film on the substrate body and further enabling formation of a film with uniform film-thickness distribution in a wide range.

### DISCLOSURE OF THE INVENTION

A substrate body floating apparatus according to the present invention is a substrate body floating apparatus for blowing an air flow to a rear surface of a disk-shaped substrate body to float and rotate the substrate body, and has a floating unit comprising a group of fine pores for centering to fix the substrate body at a center of the apparatus, a group of fine pores for rotation to rotate the substrate body at a center of the apparatus, a group of auxiliary fine pores for suppressing vibration when the substrate body is rotated at a high speed. With the features as described above, the substrate body floating apparatus according to the present invention can float and rotate a substrate body without vibration of the rotary shaft on a center line of the floating unit and also can suppress vibration of a surface of the substrate body due to rotation. As a result, the substrate body floating apparatus according to the present invention can maintain a substrate body in a stable rotating state in which the substrate body contacts nothing other than an air flow.

With the features as described above, a fine pore constituting the group of fine pores is provided on a surface of the floating unit and is inclined at an appropriate angle against a surface of the floating apparatus, and can give a floating force to the substrate body by injecting an air flow in a direction along the inclination of the fine pore. As a result, by arranging fine pores each constituting the group of fine pores at appropriate positions, it becomes possible to provide controls for floating, centering, rotating, and preventing vibration of a surface of a substrate body.

Also with the features as described above, the fine pores are provided on a surface of the floating unit, and assuming that a point where the fine pore crosses a rotation axis of the substrate body and a surface of the floating unit is divided to four areas by 90 degrees, and as each fine pore provided in one area is provided in parallel to a diagonal lime of each area and oriented to a center of the floating unit, a floating height of 1 mm or more can be obtained and also inclination of the substrate body can be suppressed to about $5 \times 10^{-3}$ rad or less with vibration of the substrate body in the horizontal direction controlled to 10 mm or below by correctly adjusting a floating gas supply rate.

Further with the features as described above, the fine pores for centering are provided on a surface of the floating unit at positions uniformly and appropriately away in the outer direction from an external periphery of the substrate body with an appropriate angular space therebetween and further each fine pore is inclined toward a center of the floating unit, so that it is possible to suppress vibration of a substrate body in the horizontal direction to about 5 mm or less at a given floating height by correctly controlling a centering gas supply rate.

Still further with the features as described above, the fine pores for rotation are provided on a surface of the floating unit, and further the fine pores are located at positions appropriately away from a tangential line to a circle with a smaller radius as compares to a radius of the substrate body around a center of a surface of the floating unit and are oriented in contrary directions alternately, so that a rotational speed of the substrate body can be changed even up to a high speed rotational speed of about 3000 rpm or more by appropriately adjusting a rotation gas supply rate. By raising a rotational speed of the substrate body, vibration of a surface of a substrate body and inclination of the substrate body can be reduced.

Especially as fine pores are located in the tangential direction and oriented in contrary directions alternately, rotation of the disk-shaped substrate body in the clockwise direction as well as in the counter-clockwise direction can be controlled under stable conditions.

With the features a described above, the auxiliary fine pores are provided on a surface of the floating unit, and further fine pores are oriented to a center of the floating unit on a circle with a larger radium as compared to that of the floating unit at an angular space of 90 degrees therebetween in the outer side from the positions of fines for rotation, so that, when a substrate body is rotated and a rotational speed of the substrate body is raised, the substrate body is prevented from jumping out from the floating apparatus (namely from the floating unit). Also vibration of a surface of a substrate body or inclination of a substrate body can be suppressed when the substrate body is rotated.

The substrate body floating type of heater according to the present invention has the substrate body floating apparatus and can heat a substrate body without losing cleanliness of a surface of a substrate body by flowing an air flow to a rear surface of the substrate body to float and rotate the substrate body and heating with an optical heating means a surface of the substrate body, and also can suppress temperature gradation generated on a surface of the substrate body.

The substrate body floating type of film-forming apparatus according to the present invention has the substrate body apparatus, and can form a film without losing cleanliness of a surface of a substrate body by blowing an air flow onto a rear surface of the substrate body under atmospheric or depressurized atmosphere to float and rotate the substrate body and by forming a film of deposited material on a surface of the substrate body. As a result, it is possible to form a film containing less impurities or other defects.

Also with the features as described above, by making an inner diameter of a nozzle for blowing a gas for film formation onto a surface of the substrate body substantially equal to an outer diameter of the substrate body and also setting a clearance between a tip of the nozzle for blowing out the gas and a surface of the substrate body to 2 mm or less, it is possible to obtain a substrate body floating type of film-forming apparatus which can form a uniform film with density gradation of a raw material used for forming a film on a substrate body in a wide range.

BRIEF DESCRIPTION OF THE DRAWINGS

Fig. 1 is a cross-sectional view schematically showing an embodiment of the substrate body floating type of apparatus according to the present invention;
Fig. 2A is a flat view showing a substrate body floating unit according to the present invention;
Fig. 2B is a cross-sectional view showing a fine pore provided in the floating unit;
Fig. 3 is a flat view schematically showing an embodiment of four fine pore groups provided on the floating unit;
Fig. 4 is a view showing an embodiment of a substrate body floating performance-assessing apparatus according to the present invention;
Fig. 5 is a graph showing dependency of a floating height, inclination, and vibration in the horizontal direction of a substrate body on a floating gas supply rate;
Fig. 6 a graph showing dependency of a floating height, inclination, and vibration in the horizontal direction of a substrate body on a centering gas supply rate;
Fig. 7 is a graph showing a relation between a rotation gas supply rate and a rotational speed;
Fig. 8 is a graph showing an auxiliary gas supply rate associated with a rotation gas supply rate;
Fig. 9 is a graph showing dependency of a floating height, inclination, and vibration in the horizontal direction of a substrate body on a rotation gas supply rate;
Fig. 10 is a view showing an embodiment of a substrate body floating type of heater according to the present invention;
Fig. 11 is a view showing a result of measurement of temperature on a surface of a substrate body;
Fig. 12 is a view showing an embodiment of a substrate body type of film-forming apparatus according to the present invention;
Fig. 13 is a cross-sectional view schematically showing a positional relation between a surface of a substrate body and a nozzle for blowing an air flow onto a surface of the substrate body;

Fig. 14 is a graph showing a result of measurement of a film thickness of an insulating film formed on a surface of a substrate body;

Fig. 15 is a graph showing a result of measurement of a film thickness in a radial direction when an insulating film is formed on a surface of a substrate body by changing a floating gas supply rate;

Fig. 16 is a graph showing a result of measurement of film thickness when an insulating film is formed on a surface of a substrate body changing a nozzle diameter and a distance between a nozzle tip and a surface of the substrate body;

Fig. 17 is a graph showing a result of measurement of film thickness in a radial direction when an insulating film is formed on a surface of a substrate body changing a nozzle diameter and a distance between a nozzle tip and a surface of the substrate body; and

Fig. 18 is a graph showing a result of measurement of a minimum gas flow rate required for floating a substrate body when inside of a heating chamber is depressurized.

(Description of Signs)

| | |
|---|---|
| 100: | Substrate body floating apparatus |
| 101: | Floating unit |
| 102: | Table |
| 103: | Supporting base |
| 104: | Floating gas supply port |
| 105: | Centering gas supply port |
| 106: | Rotation gas supply port |
| 107: | Auxiliary gas supply port |
| 108: | Air exhaust port |
| 109: | Suction port |
| 110: | File pore |
| 210: | Floating unit |
| 210: | File pore |
| 310: | Floating unit |
| 310a: | Fine pore constituting a group of fine pores for floating |
| 310b, 310c: | Fire pore constituting a group of fine pores for centering |
| 310d: | Fine pore constituting a group of fine pores for rotation |
| 310e: | Fine pore constituting a group of auxiliary fine pores |
| 400: | Substrate body floating apparatus |
| 410: | Floating unit |
| 402: | Substrate body |
| 403: | Laser displacement gauge |
| 404: | Video camera |
| 405: | CARAK |
| 406: | AD-converting board |
| 407: | Computer |

| | |
|---|---|
| 408: | Gas supply rate |
| 409: | Flow meter |
| 410: | Valve |
| 411: | Compressor |
| 412: | Air exhaust port |
| 1000: | Substrate body floating apparatus |
| 1001: | Floating unit |
| 1002: | Substrate body |
| 1003: | Heating chamber |
| 1004: | Heating means |
| 1005: | Light |
| 1006: | Thermocouple |
| 1007: | Temperature adjuster |
| 1008: | Radiation thermometer |
| 1009: | Display |
| 1010: | Gas supply port |
| 1011: | Flow meter |
| 1012: | Valve |
| 1013: | Compressor |
| 1014: | Air exhaust port |
| 1200: | Substrate body floating apparatus |
| 1201: | Floating unit |
| 1202: | Substrate body |
| 1203: | Film-forming chamber |
| 1204: | Nozzle |
| 1205: | ETES bubbler |
| 1206: | Thermostatic bath with FTES bubbler provided therein |
| 1207: | $H_2O$ bubbler |
| 1208: | Thermostatic bath with $H_2O$ bubbler provided therein |
| 1209: | Mass-flow controller |
| 1210: | Phosphorus pentaoxide |
| 1211: | Silica gel |
| 1212: | Nitrogen gas bomb |
| 1213: | Air pump |
| 1214: | Gas supply port |
| 1215: | Flow meter |
| 1216: | Valve |
| 1217: | Compressor |
| 1218: | Air exhaust port |
| 1301: | Floating unit |
| 1302: | Substrate body |
| 1303: | Nozzle |
| 1304: | Dual piping section |
| 1305: | FTES transport section |
| 1306: | $H_2O$ transport section |
| 1307: | Gas mixing section |

BEST MODE FOR CARRYING OUT THE EMBODIMENT

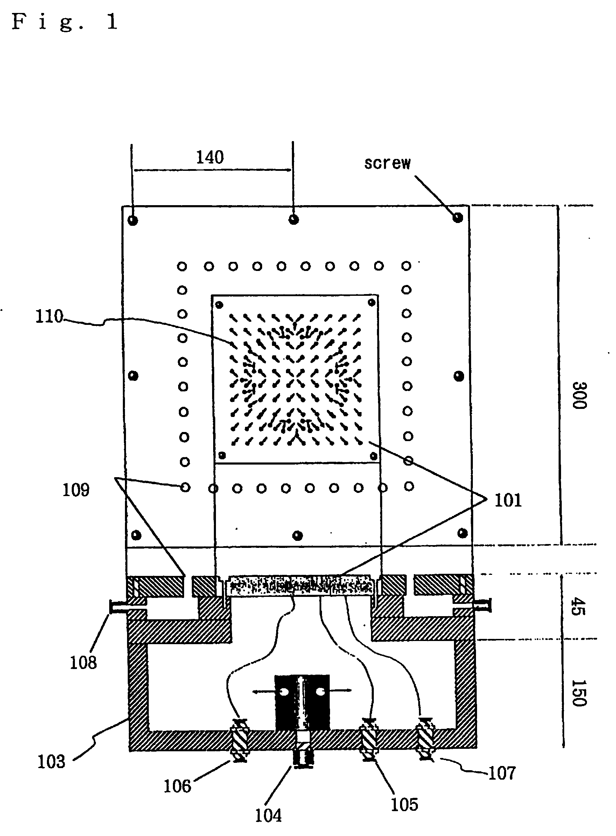

Fig. 1 is a cross-sectional view schematically showing an embodiment of a substrate body floating apparatus 100 according to the present invention. A substrate body floating apparatus shown in Fig. 1 comprises a floating unit 101, a table 102 provided along an external periphery of the floating unit 101, a supporting

4

base 103 with the floating unit 101 and table 102 placed thereon, a floating gas supporting port 104, a centering gas support port 105, a rotation gas supply port 106, an auxiliary gas supply port 107, an air exhaust port 108, a suction port 109, and a plurality of fine pores 110 provided on the floating unit 101.

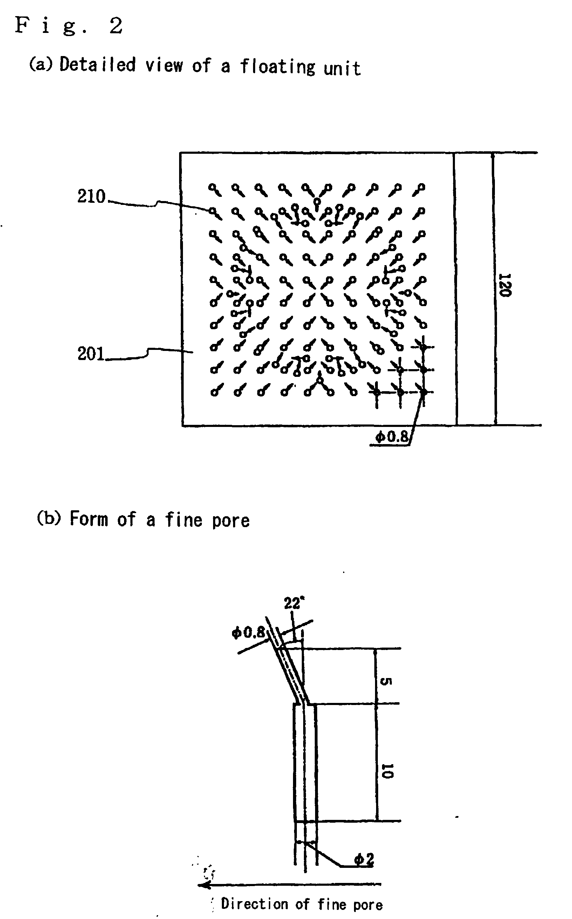

Especially a plurality of fine pores 110 provided on the floating unit 101 have the structure as shown in Fig. 2. Namely each fine pore is inclined at an angle against a surface of the floating unit toward the gas exhaust port. Fig. 2 shows a case where the fine pores is inclined at an angle of 22 degrees against a surface of the floating unit 101, and the fine pore is oriented in a direction indicated by an arrow m the figure. By setting the inclination in an arbitrary direction for exhausting gas, it becomes possible to give a floating force to a substrate body and move the substrate body in a desired direction.

Fig. 2 shows a flat view of a floating unit according to the present invention and a cross-section of a fine pore provided on the floating unit.

All of a plurality of fine pores 210 shown in Fig. 2 have the same form, and an internal diameter of each fine pore in the side of gas exhaust port is smaller as compared to that in the gas supply port, but the fine pores may have different forms respectively, and also it is needless to say that an internal diameter of each fine pore may be set to an arbitrary value.

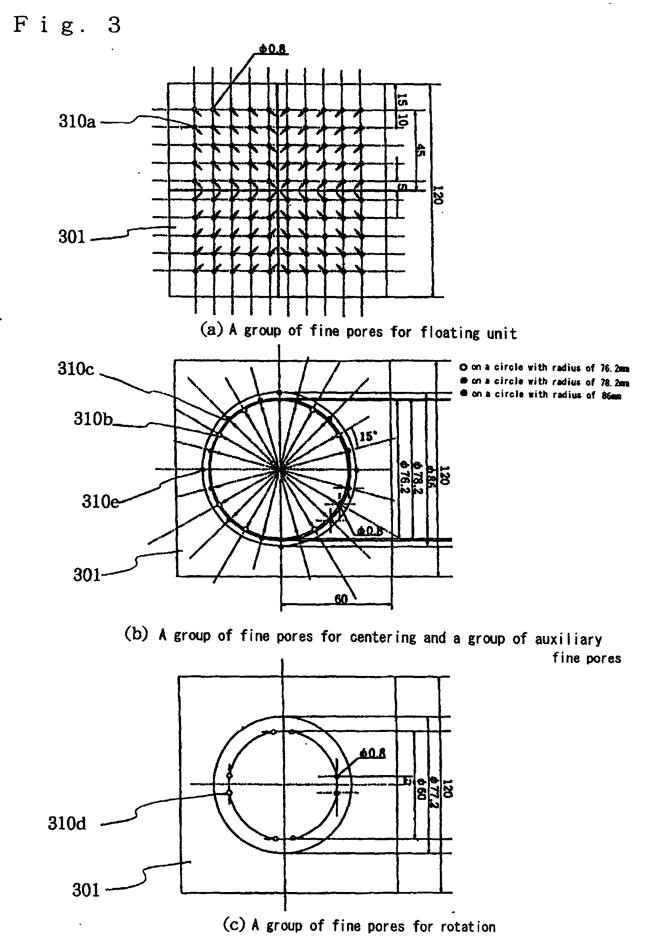

A plurality of fine pores 210 provided on the floating unit 201 shown in Fig. 2 comprises four groups of fine pores as shown in Fig.3A to Fig.3C. Namely Fig.3A shows a group of fine pores for floating, Fig.3B shows a group of auxiliary fine pores, and Fig. 3C shows a group of fine pores for rotation.

The group of fire pores shown in Fig. 3A are provided on a surface of the floating unit 101, and assuming that a point where the fine pore 310a crosses a rotation axis of a substrate body is an origin and a surface of the floating unit 301 is divided to four areas by an angle of 90 degrees, each of fine pores provided in one area are parallel to the diagonal line and oriented to a center of the floating unit 301. In Fig. 3A, the fire pores are provided at a space of 10mm therebetween and 25 pieces of fine pores are provided on one area (totally 100 fine pores on the four area).

The group of fine pores for centering shown in Fig.3B are provided on a surface of the floating unit 301, and fine pores 310b, 310c are on an external periphery of the substrate body and at positions by 1 mm outer from the external periphery at an angular space of 15 degrees alternately, and the fine pores are inclined to a center of the floating unit. However, a distance at which the fine pores are positioned in the outer side from the external peripheral of the substrate body is not limited to 1mm, nor an angular space between the two types of fine pores to 15 degrees, and the values may be decided according to a flow rate of gas injected from the fine pores or a pressure of the gas.

The group of fine pores for rotation shown in Fig. 3C are shown on a surface of the floating unit 301, and the fine pores 310d are provided at positions by 5 mm away from a tangential line to a circle of a radius of 30 mm from a center of a surface of the floating unit 301 and the fine pores are oriented in the direction of the tangential line and opposite to each other. However, a radius of the circuit for providing the fine pores are not limited to 30 mm and may be any value on the condition that the radius is smaller than a radium of the substrate body. Also positions at which the fine pores are provided are not limited to those 5 mm away from the tangential line in the direction of the tangential line, and may be set to any value according to a flow rate or a pressure of gas injected from the fine pores.

The group of auxiliary fine pores shown in Fig. 3B are provided on a surface of the floating unit 301 at positions on a circle with a radius of 40 mm in the outer side from a center of the floating unit 301 at an angular space of 90 degrees and are inclined to a center of the floating unit 301. However, a radius of the circle on which the fine pores 310e constituting the group of auxiliary fine pores is not always limited to 40 mm, and may be set to any value on the condition that the circuit is positioned in the outer side from a radium of the circuit on which the fine pores for rotation are provided. Also in Fig. 3D, fine pores constituting a group of auxiliary fine pores are provided at an angular space of 90 degrees, but also this angle may be set to an appropriate value.

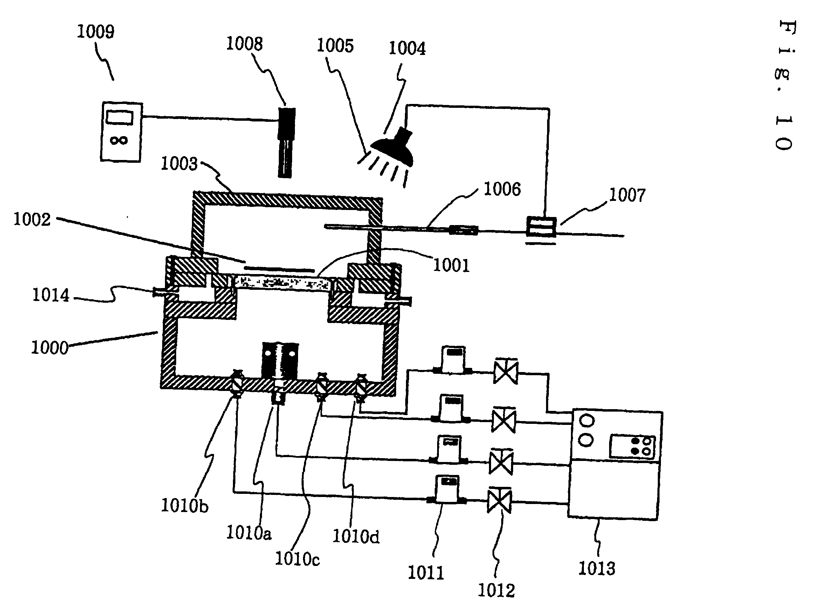

Fig. 10 is a cross-sectional view schematically showing a substrate body floating type of heater according to the present invention.

In Fig. 10, designated at the reference numeral 1000 is a substrate body floating apparatus, at 1001 a floating unit, at 1002 a substrate body, at 1003 a heating chamber, at 1004 a heating unit, at 1005 light, at 1006 a thermocouple, at 1007 a temperature adjuster, at a radiation thermometer, at 1009 a display, at 1010 a gas supply port, at 1011 a flow meter, at 1012 a valve, at 1013 a compressor, and at 1014 an air exhaust port.

In the apparatus shown in Fig. 10, the heating chamber 1003 is provided on the substrate body floating apparatus 1000. Provided on a bottom section of the heating chamber 1003 is the substrate body 1002 in a floating and rotating state with an air flow blown out from the floating unit 1001 onto a rear surface of the substrate body. Also the heating means 1004 comprising an infrared lamp is located at a position opposite to a surface of the substrate body 1002, and a light 1005 irradiated from the heating unit 1004 is irradiated to the substrate body 1002 to heat the substrate body 1002. Accordingly, in the process of forming a film, he substrate body 1002 contacts nothing other than an air flow, so that a surface of the substrate body 1002 can be heated. In Fig. 10, the heating unit 1004 is an infrared lamp, but a light source emitting a light with various types of wavelength may be used as the heating means 1004.

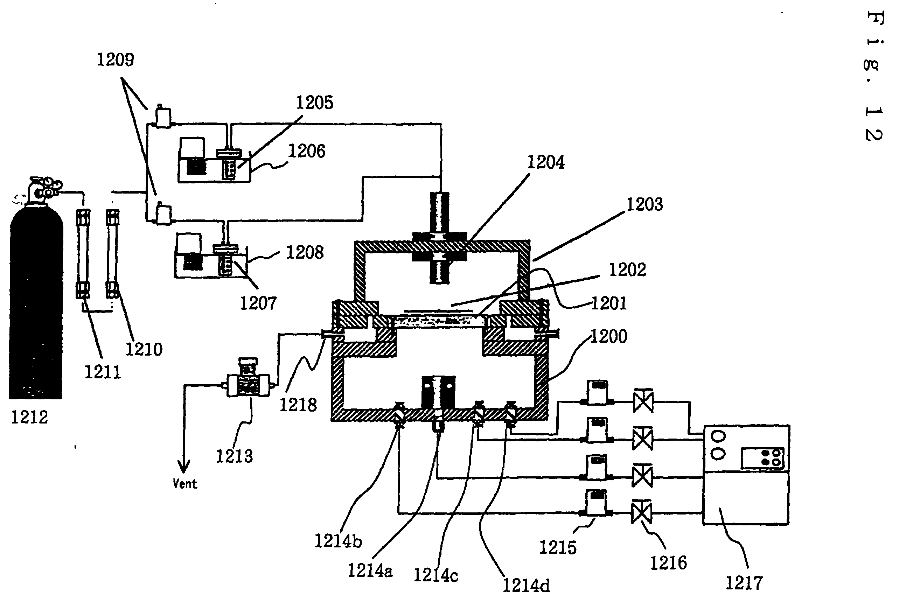

Fig. 12 is a cross-section schematically showing a substrate body floating type of film-forming apparatus according to the present invention. In Fig. 12, designated at the reference numeral 1200 is a substrate body floating apparatus, at 1201 a floating unit, at 1202 a substrate body, at 1203 a film-forming chamber, at 1204 a nozzle, at 1205 an FTES bubbler, at 1206 a thermostatic bath with the FTES bubbler placed therein, at 1207 an $H_2O$ bubbler, at 1208 a thermostatic bath with the $H_2O$ bubbler placed therein, at 1209 a mass-flow controller, at 1210 phosphorus pentaoxide, at 1211 silica gel, at 1212 a nitrogen gas bomb, at 1213 an air pump, at 1214 a gas supply port, at 1215 a flow meter, at 1216 a value, at 1217 a compressor, and at 1218 an air exhaust port.

In the apparatus shown in Fig. 12, the film-forming chamber 1203 is located on the substrate body floating apparatus 1200 (100). Above the film-forming chamber 1203, a mixed gas supply nozzle 1204 for forming a film is provided at a position opposite to a surface of the substrate body 1202, and by blowing a mixed gas for film formation onto a surface of the substrate body 1202 from this nozzle 1204, a film of deposited material is formed on a surface of the substrate body 1202. Accordingly, as a substrate body in the process of film formation contacts nothing other than an air flow, a quantity of impurities absorbed into the film can largely be reduced.

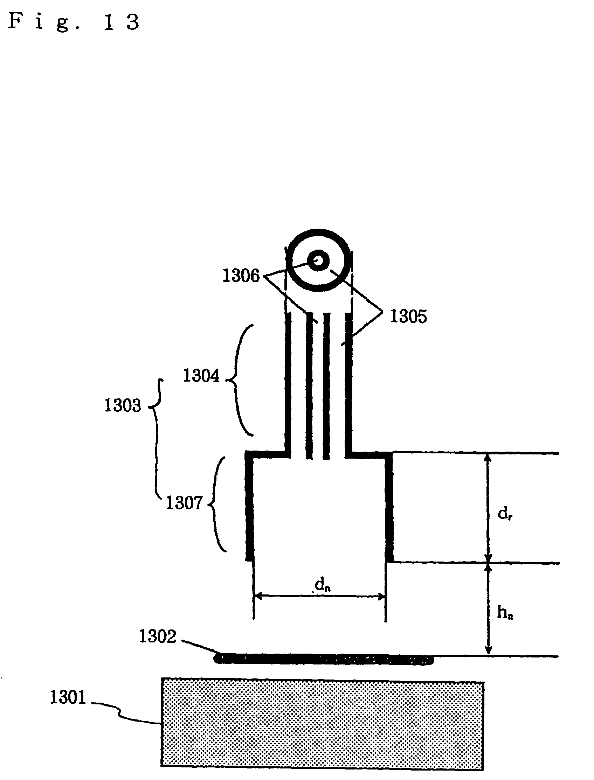

Fig. 13 is a cross-sectional view schematically showing arrangement of a substrate body and a nozzle for blowing a gas for film formation to the substrate body. In Fig. 13, by setting an internal diameter of the nozzle 1303 for blowing a gas for film formation to a surface of a substrate body (namely an internal diameter of the mixed gas mixing section 1307) and an external diameter of the substrate body 1302 to the substantially same values and also by setting a clearance between a tip of the nozzle 1303 for blowing out a gas (namely a tip of the mixed gas mixing section 1307) and a surface of the substrate body 1302 to 2 mm or below, it is possible to obtain a substrate body floating type of film-forming apparatus with smaller density gradation of a row material sprayed from the nozzle 1303 onto the substrate body 1302 uniformly applied in a wide range.

Description of the Embodiments

Next description is made for embodiments of the substrate body floating apparatus and substrate body floating type of header and film-forming apparatus according to the present invention with reference to the drawings, but it should be noted that the present invention is not limited to these embodiments.

(Embodiment 1)

In this embodiment, the substrate body floating apparatus shown in Fig. 1 is used, and a substrate body floating performance under atmospheric pressure was examined by changing a supply rate of gas flowing through the fine pores for floating (Fig. 3A) of the four fire pore groups (See Fig. 3A to Fig.3B) constituting the floating unit 101. In this step, the floating gas rate Ff was set to 0 to 50 [l/min], centering gas supply rate Cf to 0 [1/min], rotation gas supply rate Rf to 0 [l/min], and auxiliary gas supply rate Hf to 0 [l/ min].

Herein the four fire pore groups consists of a group of fire pores for floating (Fig. 3A), a group of fine pores for centering (Fig. 3B), a group of fine pores for rotation (Fig. 3C), and a group of auxiliary pores (Fig. 3B). As the substrate body, a 3-inch ⌀ wafer was used.

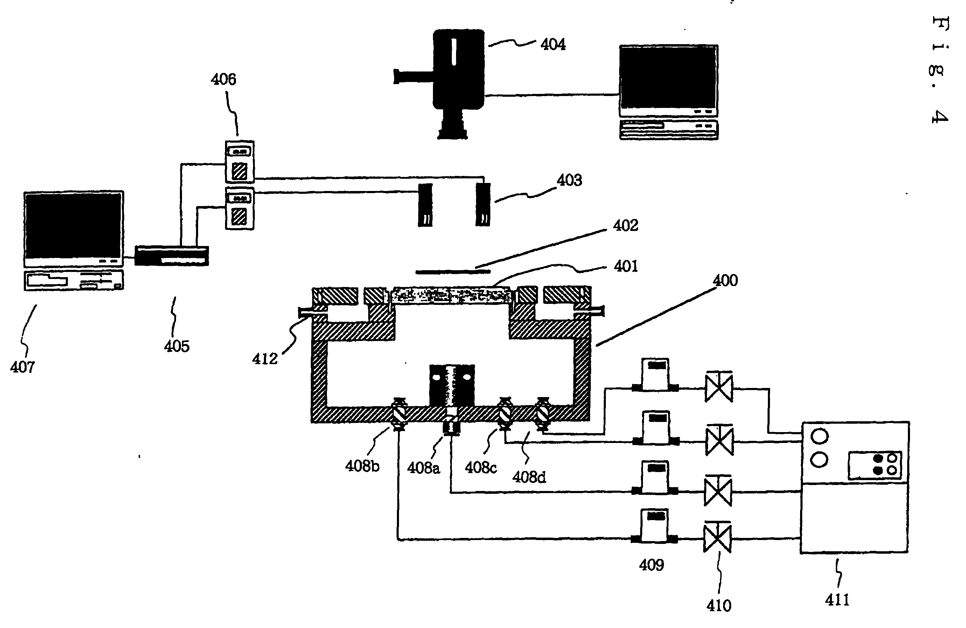

Fig. 4 is a view showing an embodiment of the substrate body floating performance assessing apparatus with a monitoring unit provided above the apparatus shown in Fig. 1 for monitoring the substrate body floating performance.

In Fig. 4, designated at the reference numeral 400 is a floating apparatus, at 401 a floating unit, at 402 a substrate body, at 403 a laser displacement gauge, at 404 a video camera, at 405 a CARAK, at 406 an AD converting board, at 407 a computer, at 408 a gas supply port, at 409 a flow meter, at 410 a valve, at 411 a compressor, and at 412 an air exhaust port.

As a monitoring unit, two laser displacement gauge were used for checking inclination of the substrate body 402, and the video camera 404 for checking displacement of the substrate body 402. When measuring a floating height of the substrate body 402, an average of measured values with the two laser displacement gauges 403 was employed. Inclination of the substrate body 402 against a surface of the floating unit 401 was obtained from a difference between the measured values obtained with the two laser displacement gauges 403 as well as from a distance between the displacement gauges. Each data was recorded into a computer with the CARAK (from Hitachi) 405 and AD conversion board 406. The data was monitored at 1/25 [sec] step for 60 seconds, and an average of all data was used as a floating height of the substrate body 402 and the maximum value of all data was used as inclination of the substrate body. When measuring vibration of the substrate body 402, a distance from a center of the substrate body to a center of the floating unit was obtained from an image taken with the video camera 404, and the value was used as a vibration width of the substrate body.

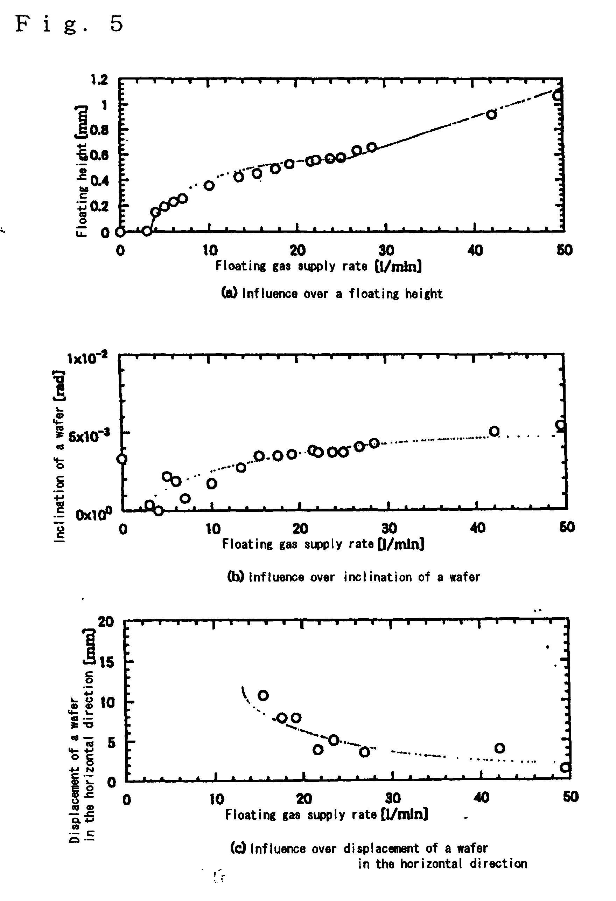

Fig. 5 is a graph showing dependency of a floating height, inclination, and displacement in the horizontal direction of a substrate body on a floating gas supply rate.

From Fig. 5, it can be confirmed that the substrate body was floated when the floating gas supply rate Ff is 3.6 [l/min] or more, and that, when the floating gas supply rate is higher than the value above, a floating height of a substrate body can be controlled in proportion of a floating gas supply rate. Also it was understood that, as a floating gas supply rate increases, displacement of the substrate body in the horizontal direction becomes smaller but inclination thereof becomes larger.

(Embodiment 2)

In this embodiment, a floating performance of a substrate body under an atmospheric pressure was examined by using the substrate body floating apparatus shown in Fig. 1 and changing a supply rate of gas flown through fire pores for centering constituting the floating unit 101. In this step, the floating gas supply rate Ff was set to 15.5, 21.6, 28.3 [l/min], centering gas supply rate Rf to 0 [l/min], and auxiliary gas supply rate Hf to 0 [l/min].

Other parameters were the same as those in Embodiment 1.

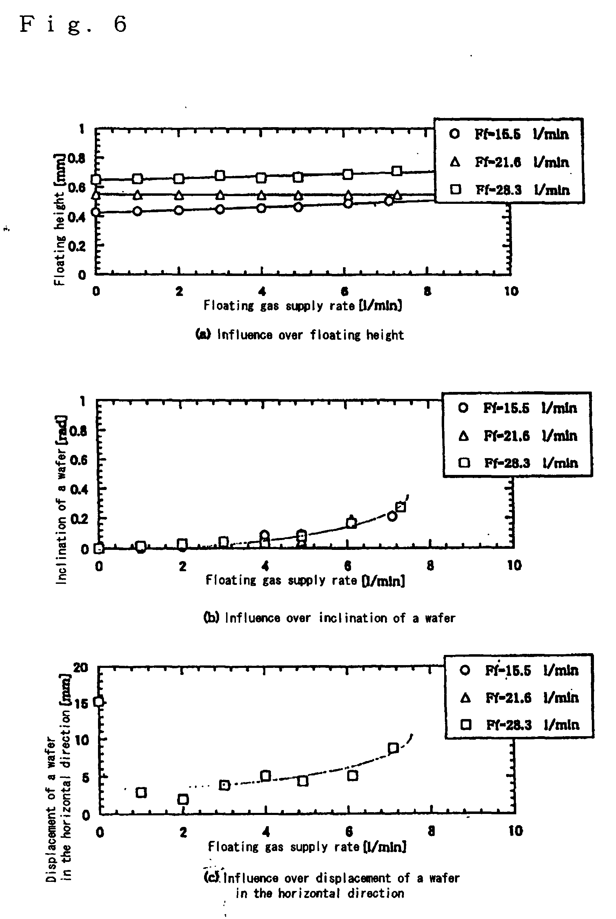

Fig. 6 is a graph showing dependency of a floating height, inclination, and displacement in the horizontal direction of a substrate body on a centering gas supply rate.

From Fig. 6 it is understood that, when a centering gas supply rate Cf is changed in a state where a substrate body is floating, a floating height of the substrate body is little affected with inclination of the substrate body becoming larger, but that displacement of the substrate body in the horizontal direction can largely be reduced. When a centering gas supply rate is excessive, displacement of the substrate body increased proportionately.

(Embodiment 3)

In this embodiment, a relation between a gas supply rate Rf under atmospheric pressure and a rotational speed Rn of a substrate body was checked by using the substrate body floating apparatus shown in Fig. 1 and changing a supply rate of gag flown through fine pores constituting a group of fine pores for ration (Fig. 3C) and a group of fine pores (Fig. 3B). In this step, the floating gas supply rate Ff was set to 15.5 [l/ min], centering gas supply rate Cf to 4.0 [l/min], a rotation gas supply rate Rf to 0 to 20 [l/min], and auxiliary gas supply rate Hf to 0 to 20 [l/min].

In this embodiment, a CCD camera was used in place of a video camera.

A substrate body was placed on a floating unit and was floated and maintained in the floating state by supplying a floating gas and a centering gas. After movement of the substrate body was substantially stabilized, a supply rate of rotation gas was gradually increased to obtain the rotational speed, and a relational expression between the supply rage rate Rf and rotational speed Rn of the substrate body was induced. The rotational speed Rn was obtained from an angular displacement rate thereof per unit time using images photographed by the CCD camera. A supply rate of auxiliary gas was increased in proportion to a rotational speed of the substrate body so that the substrate body would be stabilized.

Other factors were the same as those in Embodiment 1.

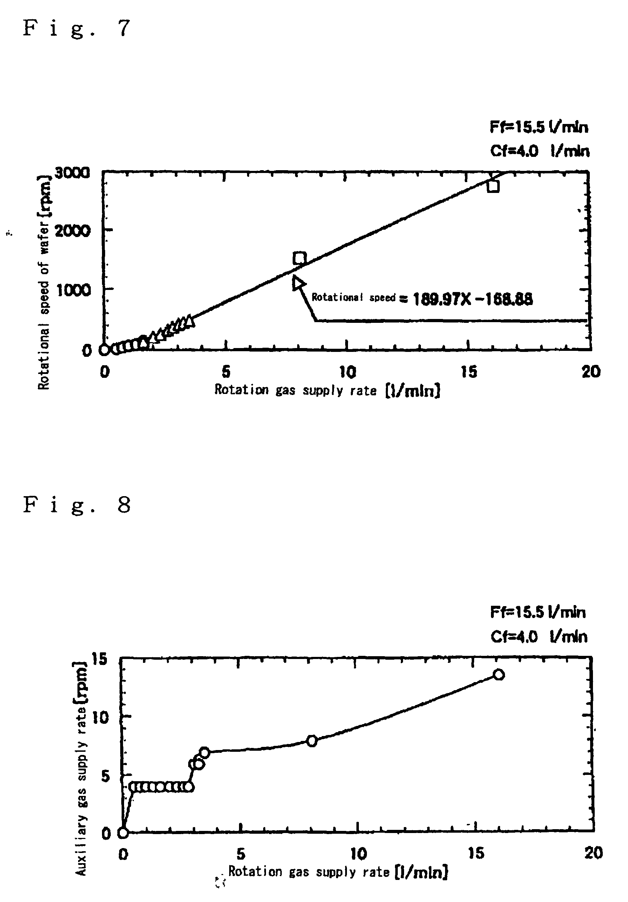

Fig. 7 is a graph showing a relation between a rotation gas supply rate and a rotational speed of a substrate body, while Fig. 8 is a graph showing an auxiliary gas supply rate associated with a rotation gas supply rate. From Fig. 7, it was confirmed that a rotational speed of a substrate body could be controlled by adjusting the rotation gas supply rate Rf. The relational expression can be expressed by the following equation:

$$Rn \text{ [rpm]} = 189.97 \times Rf \text{ [l/min]} - 168.88$$

wherein Rf > 1.2 [l/min].

Also it was understood from a result of measurement of a supply rate Hf of auxiliary gas fed to prevent the substrate body from jumping out of the floating unit when the rotational speed becomes higher (See Fig. 8) that a supply rate of auxiliary gas to be supplied increases in association with increase of a rotational speed of a substrate body.

(Embodiment 4)

In this embodiment, a floating performance of a substrate body under atmospheric pressure was examined by using the substrate body floating apparatus shown in Fig. 1 and changing a supply rate off gas flown through fine pores of the group of fine pores for rotation (Fig. 3 C) and the group of auxiliary fine pores (Fig. 3H). In this step, the floating gas supply rate Ff was set to 15.5, 21.6, 27.8 [l/min], centering gas supply rate Cf to 4.0 [l/min], rotation gas supply rate Rf to 0 to 5 [l/min], and auxiliary gas supply rate Hf to 0 to 7 [l/min].

Other factors were the same as those in Embodiment 3.

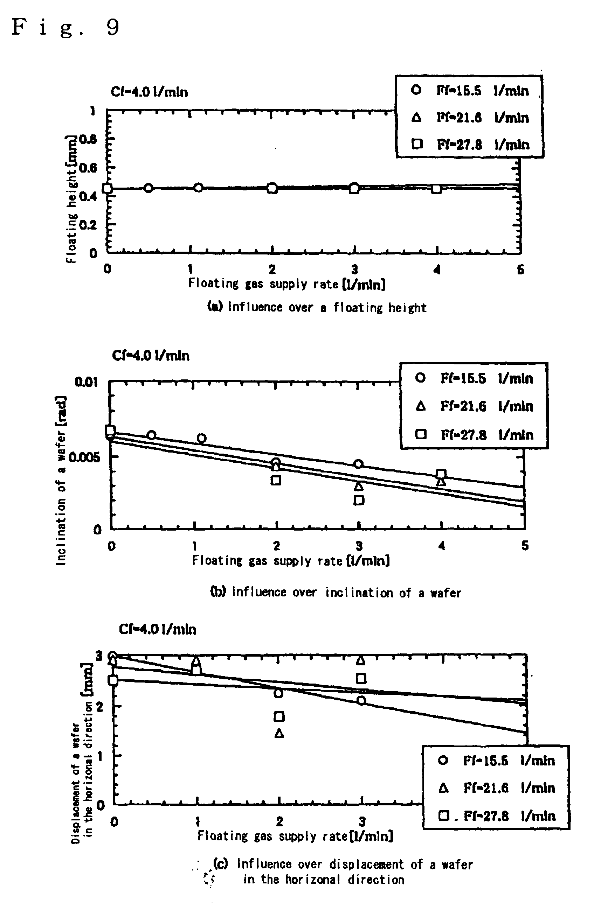

Fig. 9 is a graph showing dependency of a floating height, inclination, and displacement in the horizontal direction of a substrate body.

From Fig. 9, it was understood that, when the rotation gas supply rate Rf was increased, namely when a rotational speed of a substrate body was raised, both inclination and displacement in the horizontal direction of a substrate body are reduced. Even if the rotation gas supply rate Rf is substantially increased, deviation of a substrate body is little affected. Accordingly, it was confirmed that inclination and displacement in the horizontal direction of a substrate body can be suppressed by adjusting a rotational speed of the substrate body.

(Embodiment 5)

In this embodiment, temperature gradation on a surface of a substrate body under atmospheric pressure was checked by using a substrate body floating type of heater as shown in Fig. 10 with the substrate body floating apparatus shown in Fig. 1.

As a means for measuring temperature on a surface of the substrate body 1002 in the floating and rotating state, a radiation thermometer enabling indirect measurement 1008 was used. As the substrate body 1002, a 3-inch $\varnothing$ wafer was used.

The substrate body 1002 was placed on the floating unit 1001, and gas was supplied through each gas supply port into the four fire pore groups (Fig. 3A to Fig. 3C) to float and rotate the substrate body. In this step, the floating gas supply rate Ff was set to 15.5 [l/min], centering gas supply rate Cf to 4.0 [l/min], rotation gas

supply rate Rf to 3.0 [l/min], and auxiliary gas supply rate Hf to 4.0 [l/min].

Then, the infrared lamp 1004 was turned ON to irradiate infrared rays from outside of the heating chamber for heating the substrate body in the heating chamber 1003. Thermocouple 1006 was placed at an arbitrary point in the apparatus and was controlled with the temperature adjuster 1007 so that temperature at the position would be 50, 40, and 30°C. Temperature on a surface of the substrate body then was measured with the irradiation thermometer 1008.

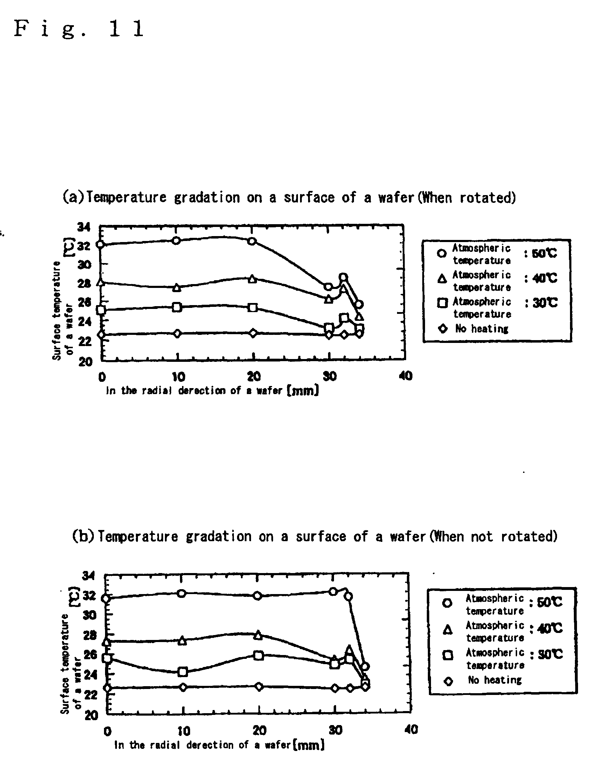

Fig. 11 shows a result of measurement of temperature on a surface of the substrate body, and Fig. 11A shows a case where the substrate body was floated, while Fig. 11B shows a case where the substrate body was floated and rotated.

It is understood from Fig. 11A that, in the state where the substrate body is not rotated, temperature gradation is generated for a distance of 30 [mm] or more in the radial direction. It can be considered that this phenomenon occurs because the substrate body does not rotate and influence of floating gas from under the substrate body is remarkable. Temperature on an entire surface of the substrate body is closed to that of the floating gas, and temperature on a surface of the substrate body is substantially influenced by temperature of the floating gas.

On the other hand, it is understood from Fig. 11B that, when the substrate body is floated and rotating, temperature gradation on a surface of the substrate body is little generated. It has not been clarified whether this phenomenon occurs because floating gas was mixed and became homogeneous due to rotation of the substrate body or because heat was delivered uniformly on a surface of the substrate body. However, temperature at a periphery of the substrate body is not dependent on the experimental conditions and shows the substantially same value as that of the floating gas, so the inventor guessed that this phenomenon occurs because a quantity of gas colliding an external edge of the substrate body is large and thermal conduction easily occurs in this section because of a large surface area as compared to that in other portions.

Temperature gradation within a range of about±1°C was recognized on a surface of a substrate body floated and rotated with the substrate body floating type of heater according to the present invention (Fig. 11B). It can be considered that temperature gradation to this degree little affects a reaction speed even when a material is deposited on the heated substrate body for film formation, and that film thickness gradation is not generated in a deposited film on the substrate body and also heterogeneous distribution of a raw material for film formation can be suppressed.

Also it was turned out that, as temperature on a surface of a substrate body was most affected by floating gas, control of temperature of the floating gas is essential for suppression of temperature on a surface of the substrate body.

(Embodiment 6)

In this embodiment) a deposited film was formed on a surface of a substrate body in a floated and rotated state by using the substrate body floating type of film-forming apparatus shown in Fig. 12 and having the substrate body floating apparatus shown in Fig. 1. Then film thickness gradation in the deposited film was examined by changing a relation between an internal diameter of a nozzle for blowing a gas for film formation onto a surface of a substrate body and an external diameter of the substrate body and a clearance between a tip of the nozzle for blowing the gas and a surface of the substrate body.

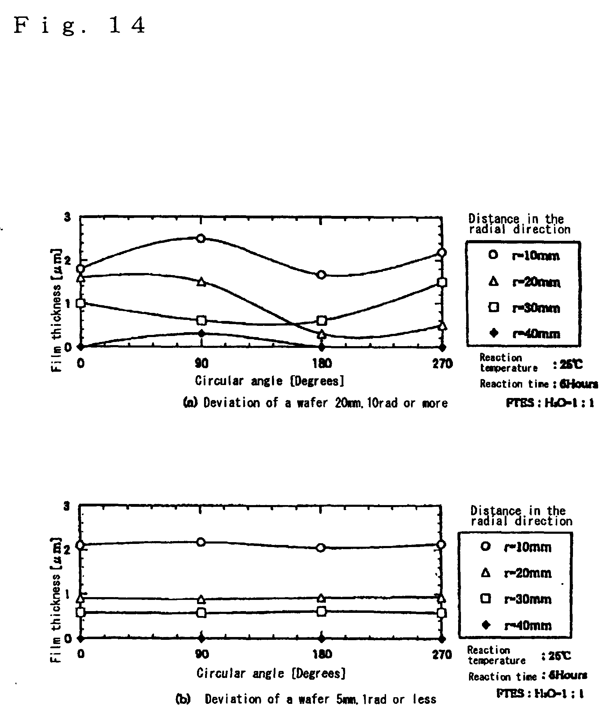

Fig. 14 is a cross-sectional view schematically showing arrangement of a substrate body and a nozzle for blowing gas for film formation. The nozzle comprises a dual piping section in which transport sections for introducing two types of gas for film formation (fluolotriethoxysilane (FTES) and $H_2O$) are combined, and a mixing section for mixing the two types of gas. In the following description dn indicates an internal diameter of the nozzle (mixed gas mixing section), dr indicates depth of the nozzle (mixed gas mixing section), and hn indicates a clearance between a tip of the nozzle (mixed gas mixing section) and a surface of a substrate body.

In the FTES used as a gas for film formation, three $OC_2H_5$ groups and one F group are coupled to each other. Physical properties of the FTES are shown in Table 1. As on of the substituents is an F group, so that the FTES is very reactive and reacts with water under room temperature to form $SiO_2$.

Table 1

Physical properties of FTES

| |
| --- |
| Molecular weight: 182.27 g/mol |
| Vapor pressure: 3.3 mmHg |
| Boiling point: 133.5°C |
| Melting point: -80.0°C |
| Density: 0.98 g/cm$^3$ |

SiO$_2$ was formed on a floated and rotated substrate body by making use of the physical properties, nd film thickness gradation generated in a peripheral direction of the substrate body was investigated.

As shown in Fig. 12 and Fig. 13, the substrate body 1002 was placed on the floating unit 1201, and the film forming chamber 1203 was shielded. Then each floating gas was supplied to float and rotate the substrate body 1202. Dry gas supplied from a compressor 1217 was passed through a trap with dry ice and liquid nitrogen to further remove moisture from the air, and the resultant air was used as the floating gas. A flow rate of each floating gas was controlled with the valve 1216 and measured with a flow meter (manufactured by STEC, Flowline). After behavior of the substrate body 1202 was stabilized to some extent, mixed gas was introduced from a nozzle above a surface of the substrate body to execute CVD processing. An internal surface of a nozzle at an mixed gas inlet port dn was set to 40 [mm] and a distance between the nozzle tip and the substrate body was set to 10 [mm].

Temperature of the thermostatic baths 1206, 1208 with FTES and H$_2$O bubblers placed therein respectively was set to 30°C and 40°C, and the vapor pressured was set to an equal level in the two baths. Then high purity nitrogen gas with moisture having been removed with phosphorus pentaoxide 1210 as carrier gas and silica gel 1211 was supplied to each bubbler at a flow rate of 100 [ml/min] from the nitrogen bomb 1212 and density ratio in the mixed gas was adjusted to 1: 1. When supplying FTES and H$_2$O into the apparatus, to prevent leakage in the piping, ribbon heater (not shown) was wound around the piping and he temperature was kept at 50°C. To prevent an internal pressure in the apparatus from becoming too high, the internal gas was sucked with an air pump 1213 [from IWAKI] at the same rate as the total gas feed rate to keep the internal pressure at a constant level. Temperature inside the apparatus was kept at 25°C and CVD processing was executed for 6 hours. Then thickness of an insulating film formed on a surface of the substrate body was measured with a scan type electronic microscope (SEM). This measurement was carried out changing behavior of the substrate body. In this experiment, as shown in Table 2, the floating gas supply rate Ff, centering gas supply rate Cf, rotation gas supply rate Rf, and auxiliary gas supply rate Hf were changed according tot he deviation rate.

(Table 2)

| Deviation | Ff | Cf | Rf | Hf |
| --- | --- | --- | --- | --- |
| 20 mm, 10 rad or more | 15.5 | 6.2 | 0 | 0 |
| 5 mm, 1 rad or less | | 4.0 | 200 | 4 |

Fig. 14 is a graph showing a result of measurement of film thickness of an insulating film formed on a surface of a substrate body. It is understood from Fig. 14 that, when a deviation rate of a substrate body is large (20mm, 10 rad or more), film thickness gradation varies in the peripheral direction.

At the same time, it can be confirmed that, when a deviation rate of a substrate body is small (5 mm, 1 rad or less), film thickness gradation is little generated in the peripheral direction. The value for deviation of a substrate body of 5 mm and 1 rad or more is unrealistic when the floating unit according to the present invention is used. Accordingly, when a film is formed on a surface of a substrate body with the substrate body floating type of film forming apparatus according to the present invention is used, it is possible to form a film with no film thickness gradation in the peripheral direction.

(Embodiment 6)

This Embodiment is different from Embodiment 5 in that the substrate body floating type of film forming apparatus as shown in Fig. 12 with the substrate body floating apparatus shown in Fig. 12 incorporated therein was used and that a floating gas supply rate was changed when a deposited film was formed on a surface of a substrate body in a floated and rotated state.

Namely, in this embodiment, the floating gas supply rate Ff was set to 5.0, 15.5, and 21.6 [l. min], centering gas supply rate Cf to 4.0 [l/min], rotation gas supply rate Rf to 200 [l/min], auxiliary gas supply rate Hf to 4 [l/min], nozzle diameter dn to 40 [mm], and a distance between the nozzle tip and substrate body hn to 10 [mm].

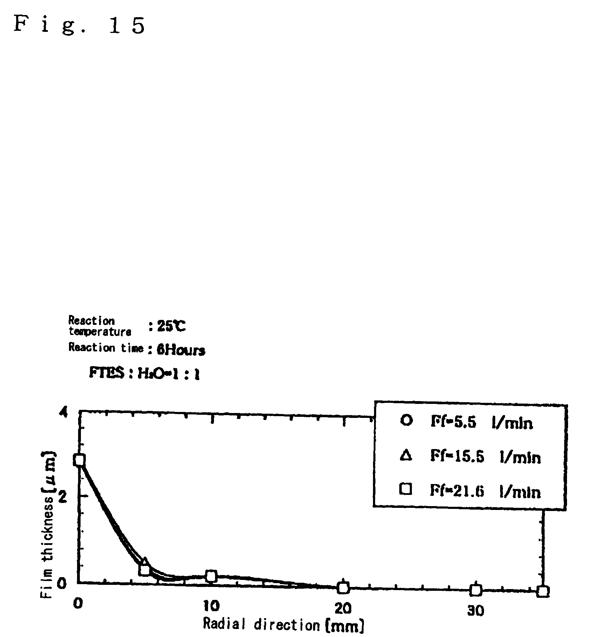

Fig. 15 is a graph showing a result of measurement of film thickness in the radial direction when an insulating film was formed on a surface of a substrate body changing a floating gas supply rate. It is understood from Fig. 15 that a floating gas supply rate little affects gradation of film thickness in the radial direction. A number of fine pores for floating are many, 100 pieces, and it can be considered that, even if the floating gas supply rate is raised a little, an injection speed from an outlet port of each fine pore does not become so high and the injection speed is little affected as compared to a case of other types of fine pores. The influence may appear when the floating gas supply rate increases, but the floating gas supply rate Ff of 15.5 [l/min] is enough for floating a substrate body, so the inventor considered that investigation for a higher supply rate was unnecessary; and that film thickness gradation in the radial direction on a surface of a substrate body is not improved by adjusting the floating gas supply rate.

(Embodiment 7)

In this Embodiment the substrate body floating type of film-forming apparatus shown in Fig. 12 with the substrate body floating apparatus shown in Fig. 1 incorporated therein was used, but this embodiment is different from Embodiment 5 in that a nozzle diameter and a distance between a nozzle tip and a substrate body were changed when forming a deposited film on a surface of a substrate body in a floated and rotated state.

Namely, operating conditions in this embodiment includes the floating gas supply rate Ff of 15.5 [l/min], centering gas supply rate Cf of 4.0 [l/min], rotation gas supply rate Rf of 200 [l/min], auxiliary gas supply rate Hf of 4 [l/min], nozzle diameter dn of 1/2 [inch], 1 [inch], 30 [mm], 40 [mm], 75 [mm], and a distance hn between the nozzle tip and a substrate body of 1,2, 5,10, and 30, 50.

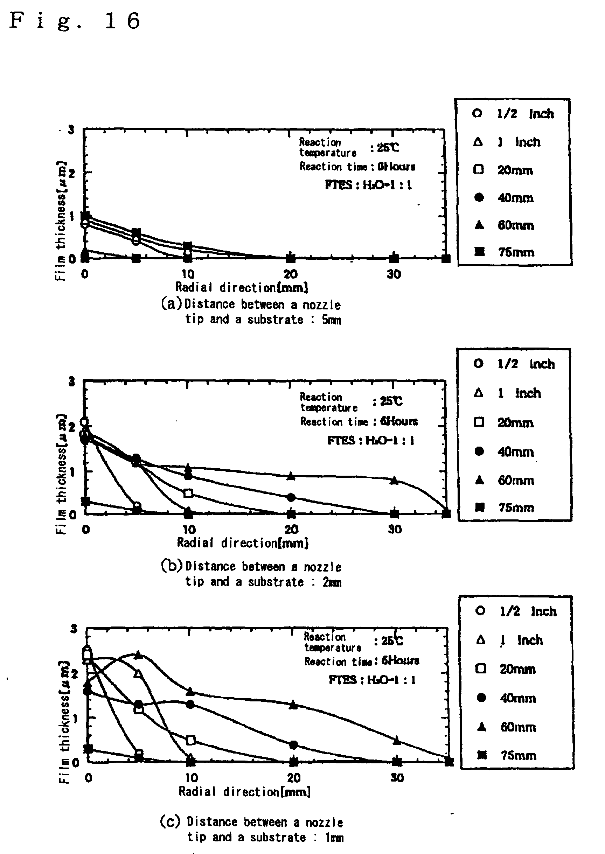

Fig. 16 is a graph showing a result of measurement of film thickness in the radial direction when an insulating film was formed on a surface of a substrate body changing a nozzle diameter and a distance between the nozzle tip and a substrate body. It is understood from Fig. 16 that a film is little formed when a distance between the nozzle tip and a substrate body is 5 mm or more. The inventor considered that this phenomenon occurred because a flow of mixed gas supplied from the nozzle was impeded by gas injected from under the substrate body and the mixed gas was diffused before reaching a surface of the substrate body. Also the inventor guessed that, when the distance is large, the reaction proceeds before the gas reaches the substrate body with the gas density becoming lower before reaching a surface of the substrate body, and that it prevented the reaction. Also it was turned out that, even when the distance is small, if the nozzle diameter is too small, a film can not be formed in a sufficiently wide range. The inventor guessed that the phenomenon occurred because the residing time was limited to 5 sec and a flow rate was small due to the small nozzle diameter and the gas was substantially diluted by the floating gas. Also it was turned out that, when a distance between the nozzle tip and a surface of the substrate body was limited to 1 mm or below, a film could be formed at a high speed. In this case, however, it was confirmed that not a film but a collection of granular reaction intermediates was deposited on a surface of the substrate body. It was guessed that this phenomenon occurred because the distance between the nozzle tip and a surface of the substrate body was too small, the mixed gas did not flow smoothly on a surface of the substrate body and resided for s relatively long time on the surface, and reaction proceeded rapidly.

Also it was understood from a result shown in Fig. 16 that, when a nozzle diameter is larger, a film can be formed in a wider range. The inventor guessed that this phenomenon occurred because the mixed gas could homogeneously be supplied over a surface of the substrate body with a nozzle with a larger diameter. However, when the nozzle diameter dn is larger than 75 mm, film thickness gradation became more remarkable. It was guessed that this phenomenon occurred because the gas injected from under the substrate body went into the nozzle, the mixed gas inside the nozzle was diluted by the floating gas, and the density became lower.

Accordingly it was determined that it was necessary to set a distance between the nozzle tip and a surface of a substrate body to about 2 mm and also to make the nozzle diameter equal to a diameter of the substrate body for forming a homogeneous film in a wide range on a surface of the substrate body. Namely by getting closer a nozzle with a large diameter, a film could easily be formed because influence of injected gas to a surface of the substrate body can be reduced.

In this embodiment, although the time for mixing (supplying) the gas for film formation was set to 5 sec, but there was a concern about the possibility that a residing time of the gas for film formation on a surface of a substrate body might affect gradation of film thickness. However, a flow of the gas in the radial direction on a surface of the substrate body was quick and τ was 0.5 sec when a rotational speed Rn of the substrate body was 200 rpm, and for this reason the inventor considered that a residing time of gas on a surface of a substrate body would not affect the film thickness gradation.

(Embodiment 8)

In this Embodiment, the substrate body floating type of film-forming apparatus shown in Fig. 12 with the substrate body floating apparatus shown in Fig. 1 incorporated therein was used, but the embodiment was different from Embodiment 5 in the point that the nozzle diameter and a rotational speed of the substrate body were changed when a deposited film was formed on a surface of the substrate body in a floated and rotated state. In this case, a flow rate of the mixed gas was decided so that an injection speed at an outlet port of the nozzle became equal, and also a distance of the mixing section was set so that the mixing time was 5 sec. Depending on a result obtained in Embodiment 7, a distance between the nozzle tip and a surface of the substrate body was set to 2 mm.

Namely as operating conditions in this embodiment, the floating gas supply rate Ff was set to 15. 5 [l/min], centering gas supply rate Cf to 4.0 [l/min], rotational speed of the substrate body Rn to 20.0, 400, 700, 800 rpm, auxiliary gas supply rate Hf to 4.0, 6.0, 7.0 [l/min], nozzle diameter dn to 40, 60, 70 mm, and a distance between the nozzle tip and a substrate body hn to 2 mm.

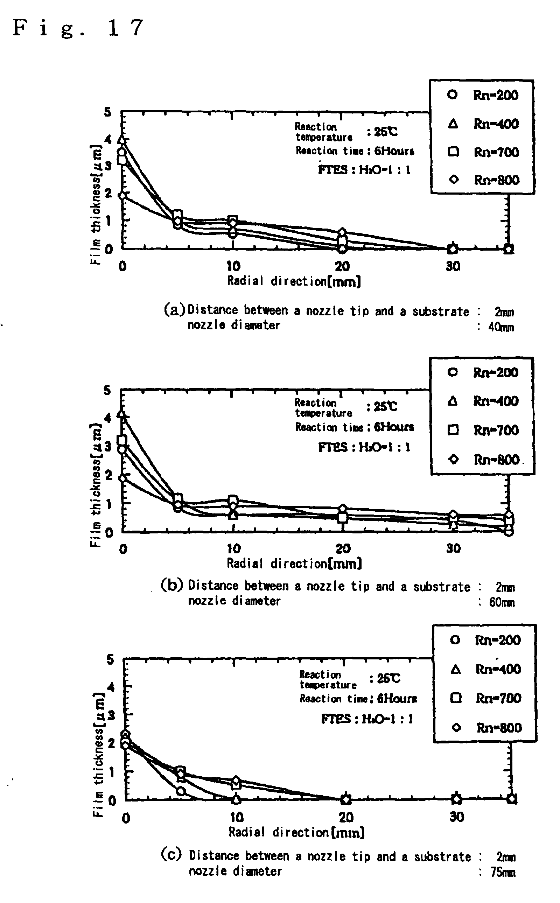

Fig. 17 is a graph showing a result of measurement of film thickness in the radial direction when an insulating film is formed changing a nozzle diameter and a rotational speed of the substrate body. It is understood from Fig. 17 that, as a rotational speed of a substrate body becomes higher, a uniform film can be formed in a wider range. The inventor guessed that this phenomenon occurred because, when a rotational speed of the substrate body is high, a moving speed of the mixed gas in the radial direction on a surface of the substrate body became faster and a difference between density of the mixed gas in the upstream section and that in the downstream section disappeared. From this result, it was confirmed that, even when a substrate body is floated and affected by floating gas blown from under the substrate body, the pumping action specific to the rotational type of CVD apparatus is effected. However generation of the pumping action and formation of a uniform film in a wide range were confirmed only when the internal diameter of the nozzle was 60 mm. In other cases, a uniform film could not be formed. It was guessed that this phenomenon occurred because the mixed gas was diluted by the floating gas.

(Embodiment 9)

In this Embodiment, the substrate body floating type of heater as shown in Fig. 10 with the substrate body floating apparatus as shown in Fig. 1 was used, and a floating performance of a substrate body and temperature gradation on a surface of the substrate body were investigated. By connecting a vacuum pump (not shown) to the air exhaust port 1014, inside of the heating chamber 1003 was controlled to an appropriately depressurized state.

Other conditions were the same as those in Embodiment 5.

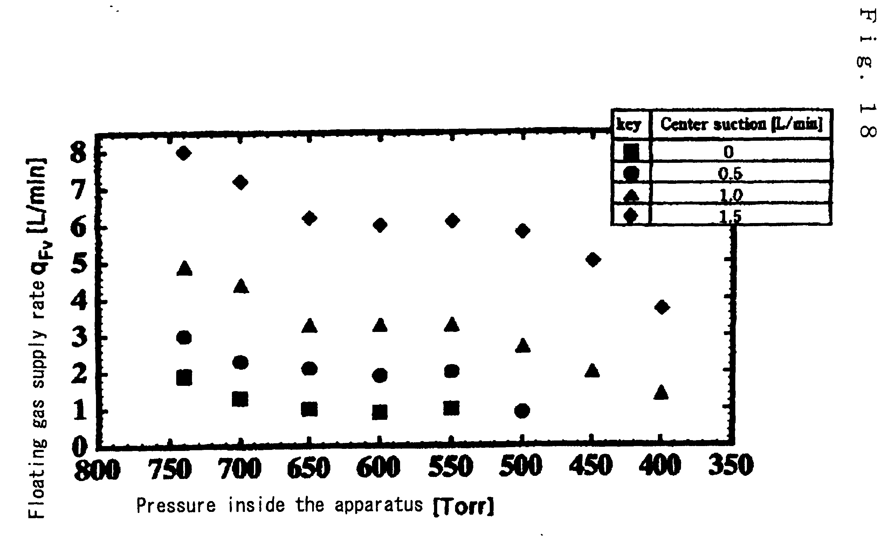

Fig. 18 shows a result of measurement of a minimum gas flow rate required for floating a substrate body when inside of the heating chamber is depressurized. All of the gas flow rates were converted to values under 20°C and 1 atmospheric pressure. In this case, it was visually confirmed that the substrate body was floated to a height within about 1 mm. Also to stabilize behavior of the substrate body, a gas exhaust rate from a center of the control unit was appropriately changed as an experimental parameter.

It is understood from Fig. 18 that the substrate body floating apparatus according to the present invention could float a substrate body even in depressurized atmosphere. Fig. 18 shows a result in a state where the pressure inside the apparatus was at maximum 400 Torr, but it was confirmed that a substrate body could be floated even when the pressure in the apparatus was about50 Torr.

Also it is understood that, as the pressure inside the apparatus is lowered, a minimum gas flow rate required for floating the substrate body decreases.

Further temperature gradation on a surface of a substrate body in a depressurized atmosphere was the same as that under the atmospheric pressure (as shown in Fig. 11), and it was confirmed that heating was sufficiently executed even under depressurized conditions.

(Embodiment 10)

In this Embodiment, the substrate body floating type of film-forming apparatus as shown in Fig. 12 with the substrate body floating apparatus as shown in Fig. 1 incorporated therein was used, and a deposited film was formed on a surface of a substrate body in a floated and rotated state. In this step, a vacuum pump (not shown) was connected to the air exhaust port 1218 to depressurize inside of the film-forming chamber 1203 to an appropriate level.

Other operating conditions were the same as those in Embodiment 6.

Result of experiment in this embodiment (namely a result in a depressurized atmosphere) is the same as that obtained under the atmospheric pressure (as shown in Fig.15), and it was confirmed that film formation could be performed even under depressurized conditions.

APPLICABILITY FOR INDUSTRIAL PURPOSES

As described above, with the present invention, a substrate body floating apparatus which can realize a floating state of a substrate body with less vibration of the rotation axis or a surface thereof can be obtained. Also by making use of the substrate body floating apparatus according to the present invention, it is possible to obtain a substrate body floating type of heater and film-forming apparatus which can form a film with uniform thickness in a wide without losing cleanliness of a surface of a substrate body and with small temperature gradation on s surface of a substrate body as well as small density gradation of a raw material used for forming a film on the substrate body.

**Claims**

1. A substrate body floating apparatus for blowing an air flow onto a rear surface of a disk-shaped substrate body to float and rotate the substrate body comprising a floating unit; wherein said floating unit comprises a group of fine pores for floating the substrate body, a group of fine pores for centering and fixing the substrate body at a center of the apparatus, a group of fine pores for rotating the substrate body at a center of the apparatus, and a group of auxiliary fine pores for suppressing vibration of the substrate body when the substrate body is rotated at a high speed.

2. The substrate body floating apparatus according to Claim 1; wherein fine pores constituting the group of fine pores are provided on a surface of the floating unit,

> are inclined against a surface of the floating apparatus,
> and an an flow is injected from the fine pores in a direction of the inclination.

3. The substrate body floating apparatus according to Claim 2; wherein the group of fine pores for floating are provided on a surface of the floating unit, and assuming that the fine pore crosses a rotation axis of the substrate body is an origin ad a surface of the floating unit is divided to four areas by an angular space of 90 degrees, files provided in one area are parallel to the diagonal line and are oriented to a center of the floating unit.

4. The substrate body floating apparatus according to Claim 2; wherein the group of fire pores for centering are provided on a surface of the floating unit, the fire pores are located at positions on an outer periphery of the substrate body or in the outer side from the periphery at an appropriate angular space alternately, and the fine pores are oriented to a center of the floating unit.

5. The substrate body floating apparatus according to Claim 2; wherein the group of fine pores for rotation are provided on a surface of the floating unit, and the fire pores are located at positions away by an appropriate distance from a tangential line to a circle with a radius smaller to that of the substrate body drawn from a center of a surface of the floating unit and also the fine are oriented in the tangential direction in opposite directions alternately.

6. The substrate body floating apparatus according to Claim 2; wherein the group of auxiliary fine pores is provided on a surface of the floating unit, the fine pores are oriented to a center of the floating unit and located on a periphery of a circle in the outer side than the fire pores for rotation from a center of the floating unit at an angular space of 90 degrees therebetween.

7. A substrate body floating type of heater having the substrate body floating apparatus; wherein an air flow is blown to a rear surface of the substrate body to float and rotate the substrate body and a surface of the substrate body is heated by an optical heater.

8. A substrate body floating type of film-heating apparatus having the substrate body floating apparatus; wherein an air flow is blown onto a rear surface of the substrate body to float and rotate the substrate body under the atmospheric pressured or under depressurized conditions for forming a film of deposited material on a surface of the substrate body.

9. The substrate body floating type of film-forming apparatus according to Claim 8; wherein an internal diameter of a nozzle for blowing gas for film formation onto a surface of the substrate body and an external diameter of the substrate body are set to the substantially same values and a clearance between a tip of the nozzle for blowing the gas and a surface of the substrate body is set to 2 mm or below.

F i g .  1

# Ｆｉｇ．２

(a) Detailed view of a floating unit

210

201

120

φ0.8

(b) Form of a fine pore

22°

φ0.8

5

10

φ2

Direction of fine pore

F i g . 3

φ0.8

310a

301

15 10

45

5

120

(a) A group of fine pores for floating unit

310c

310b

310e

301

15°

φ0.8

60

O on a circle with radius of 76.2mm
● on a circle with radius of 78.2mm
● on a circle with radius of 86mm

φ86
φ78.2
φ76.2

120

(b) A group of fine pores for centering and a group of auxiliary
fine pores

φ0.8

310d

301

5

φ60
φ77.2

120

(c) A group of fine pores for rotation

# Fig. 4

# F i g . 5

(a) Influence over a floating height

(b) Influence over inclination of a wafer

(c) Influence over displacement of a wafer
in the horizontal direction

# Ｆｉｇ．　6

(a) Influence over floating height

(b) Influence over inclination of a wafer

(c) Influence over displacement of a wafer
in the horizontal direction

F i g . 7

Ff=15.5 l/min
Cf=4.0 l/min

Rotational speed ≈ 189.97X − 168.88

F i g . 8

Ff=15.5 l/min
Cf=4.0 l/min

# Fig. 9

Cf=4.0 l/min

| | |
|---|---|
| O | Ff=15.5 l/min |
| △ | Ff=21.6 l/min |
| □ | Ff=27.8 l/min |

Floating height [mm]

Floating gas supply rate [l/min]

(a) Influence over a floating height

Cf=4.0 l/min

| | |
|---|---|
| O | Ff=15.5 l/min |
| △ | Ff=21.6 l/min |
| □ | Ff=27.8 l/min |

Inclination of a wafer [rad]

Floating gas supply rate [l/min]

(b) Influence over inclination of a wafer

Cf=4.0 l/min

| | |
|---|---|
| O | Ff=15.5 l/min |
| △ | Ff=21.6 l/min |
| □ | Ff=27.8 l/min |

Displacement of a wafer in the horizonal direction [mm]

Floating gas supply rate [l/min]

(c) Influence over displacement of a wafer in the horizonal direction

F i g. 1 0

# F i g. 1 1

(a)Temperature gradation on a surface of a wafer(When rotated)

(b) Temperature gradation on a surface of a wafer(When not rotated)

Fig. 1 2

Fig. 13

# F i g. 1 4

(a) Deviation of a wafer 20mm, 10rad or more

(b) Deviation of a wafer 5mm, 1rad or less

Fig. 15

Reaction
temperature : 25℃

Reaction time : 6Hours

FTES : H₂O＝1 : 1

Fig. 16

(a) Distance between a nozzle
tip and a substrate : 5mm

(b) Distance between a nozzle
tip and a substrate : 2mm

(c) Distance between a nozzle
tip and a substrate : 1mm

Ｆｉｇ．１７

(a) Distance between a nozzle tip and a substrate : 2mm
nozzle diameter : 40mm

(b) Distance between a nozzle tip and a substrate : 2mm
nozzle diameter : 60mm

(c) Distance between a nozzle tip and a substrate : 2mm
nozzle diameter : 75mm

Fig. 18

# INTERNATIONAL SEARCH REPORT

International application No.

PCT/JP98/01070

| A. CLASSIFICATION OF SUBJECT MATTER |
|---|
| Int.Cl⁶ H01L21/68, B23Q3/08 |
| According to International Patent Classification (IPC) or to both national classification and IPC |

| B. FIELDS SEARCHED |
|---|
| Minimum documentation searched (classification system followed by classification symbols) |
| Int.Cl⁶ H01L21/68, B23Q3/08 |

| Documentation searched other than minimum documentation to the extent that such documents are included in the fields searched |
|---|
| Jitsuyo Shinan Koho 1926-1997 Kokai Jitsuyo Shinan Koho 1971-1997 Toroku Jitsuyo Shinan Koho 1994-1997 |

| Electronic data base consulted during the international search (name of data base and, where practicable, search terms used) |
|---|
|  |

## C. DOCUMENTS CONSIDERED TO BE RELEVANT

| Category* | Citation of document, with indication, where appropriate, of the relevant passages | Relevant to claim No. |
|---|---|---|
| Y | JP, 59-215718, A (Kokusai Electric Co., Ltd.), December 5, 1984 (05. 12. 84) (Family: none) | 1-9 |

☐ Further documents are listed in the continuation of Box C.　☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | |
| "O" document referring to an oral disclosure, use, exhibition or other means | "Y" document of particular relevance; the claimed invention cannot be considered to involve an inventive step when the document is combined with one or more other such documents, such combination being obvious to a person skilled in the art |
| "P" document published prior to the international filing date but later than the priority date claimed | "&" document member of the same patent family |

| Date of the actual completion of the international search | Date of mailing of the international search report |
|---|---|
| May 25, 1998 (25. 05. 98) | June 9, 1998 (09. 06. 98) |

| Name and mailing address of the ISA/ | Authorized officer |
|---|---|
| Japanese Patent Office | |
| Facsimile No. | Telephone No. |

Form PCT/ISA/210 (second sheet) (July 1992)